# EUROPÄISCHE PATENTANMELDUNG

(11) **EP 4 528 570 A1**
(43) Veröffentlichungstag der Anmeldung: **26.03.2025**
(21) Anmeldenummer: 23199346.0
(22) Anmeldetag: 25.09.2023
(51) Int. Cl.: G06F 30/00, G06T 19/20

(54) **VERFAHREN ZUM AUTOMATISIERTEN GENERIEREN EINER TECHNISCHEN MONTAGEANLEITUNG AUS EINEM DIGITALEN MODELL**

(71) Anmelder: Assemblio GmbH, 71384 Weinstadt (DE)
(72) Erfinder: Popper, Jens, 71384 Weinstadt (DE); Neb, Alexander, 71384 Weinstadt (DE)
(74) Vertreter: dompatent von Kreisler Selting Werner - Partnerschaft von Patent- und Rechtsanwälten mbB

(57) **Zusammenfassung**

Verfahren und Vorrichtung zur automatisierten Generierung einer technischen Montageanleitung aus einem digitalen Modell, insbesondere einem CAD-Modell, eines zusammengesetzten Gegenstandes. Durch die schrittweise Demontage der Bauteile des digitalen Modells in umgekehrter Reihenfolge wird die technische Montageanleitung erstellt.

## Beschreibung

Die Erfindung betrifft ein Verfahren und eine Vorrichtung sowie ein computerlesbares Medium, zum automatisierten Generieren einer technischen Montageanleitung aus einem digitalen Modell eines zusammengesetzten Gegenstandes, insbesondere eines CAD Modells.

Technische Montageanleitungen sind ein wesentlicher Bestandteil von Herstellungs- und Montageprozessen in verschiedensten Branchen. Obwohl CAD-Software bereits die Möglichkeit bietet, dreidimensionale Modelle zu erstellen und diese detailreich darzustellen, erfordert die Generierung einer umfassenden technischen Montageanleitung bisher einen großen manuellen Aufwand. Das Hauptproblem besteht darin, dass jede einzelne Bewegung, jeder Montageschritt und jedes Werkzeug manuell in die Anleitung eingefügt werden müssen. Diese müssen logisch miteinander verknüpft werden. Dieser Prozess ist zeitraubend und fehleranfällig.

Aufgabe der Erfindung ist es, ein automatisiertes Verfahren zum Generieren einer technischen Montageanleitung aus einem digitalen Modell des zu montierenden Gegenstandes bereitzustellen.

Die Lösung dieser Aufgabe erfolgt erfindungsgemäß durch die Merkmale der Ansprüche 1, 14 und 15.

Die Erfindung betrifft ein Verfahren zum automatisierten Generieren einer technischen Montageanleitung aus einem digitalen Modell eines zusammengesetzten Gegenstandes, insbesondere eines CAD Modells, wobei das digitale Modell mindestens zwei Bauteile aufweist. Das erfindungsgemäße Verfahren ist gekennzeichnet durch folgende Verfahrensschritte:
a. Schrittweises Demontieren der Bauteile des digitalen Modells
b. Erstellen der technischen Montageanleitung auf Basis des schrittweisen Demontierens in umgekehrter Reihenfolge.

Die Erfindung geht aus von einem realen Gegenstand, welcher einer Montage bedarf. Solche realen Gegenstände können zum Beispiel Möbel, Spielzeuge, Elektrogeräte, Autos, Heizungssysteme, Wassersysteme, elektrische Systeme betreffen sowie Bauteile oder Baugruppen dieser genannten Gegenstände betreffen.

Der erfindungsgemäß reale Gegenstand liegt im zusammengebauten Zustand als digitales Modell vor. So ein digitales Modell kann zum Beispiel in einem CAD Format, in einem neutralen Austauschformat wie zum Beispiel STEP, STP, JT oder Obj vorliegen.

Das erfindungsgemäße digitale Modell muss zwei oder mehr Bauteile enthalten, deren Montage in einer technischen Montageanleitung dargestellt werden soll.

Das Erstellen der technischen Montageanleitung erfolgt durch schrittweises Demontieren der Bauteile des digitalen Modells in umgekehrter Reihenfolge. In anderen Worten startet das erfindungsgemäße Verfahren mit dem zusammengebauten digitalen Modell und endet mit einem Subset von Bauteilen, die das Verfahren als letztes demontiert. Die Montage Anleitung startet ausgehend von dem Subset an Bauteilen und geht Schritt für Schritt die Demontage rückwärts durch und endet mit dem vollständig zusammengebauten digitalen Modell. Dieser Vorgang wird auch "assembly by disassembly" genannt.

In einem optionalen Schritt werden bevorzugt Bauteile in dem digitalen Modell identifiziert. Hierfür kann zum Beispiel die Baumgruppenstruktur des digitalen Modells berücksichtigt werden. Zusammen mit einem nicht erfindungsgemäßen Algorithmus oder KI-Algorithmus werden einzelne Bauteile aus dem digitalen Modell isoliert.

In einem weiteren optionalen Schritt werden primitive Kontaktfeatures zwischen Bauteilen bestimmt. Hierfür kommt die Bestimmung von Kontaktfeatures zwischen allen Bauteilen, einem Subset von Bauteilen, oder Bauteilen, die sich berühren oder in einem bestimmten Abstand zueinander liegen, in Frage.

Ein primitives Kontaktfeature ist ein Kontakt zwischen zwei oder mehr Bauteilen, die sich in einem sehr kleinen oder gar keinem Abstand zueinander befinden. Dieser Abstand kann zum Beispiel im einstelligen Mikrometerbereich liegen, zum Beispiel -1 µm, 0 µm oder +1 µm sein. Die Art des Kontakts wird ebenfalls im primitiven Kontaktfeature bestimmt. Kontaktarten können sein: planare Kontakte (zwei Flächen berühren sich), zylindrische Kontakte (eine Zylinderfläche berührt eine andere Zylinderfläche, wie eine Welle in einem Lager), Punktkontakte, Torus-Kontakte, Spline-Kontakte (z.B. das Gewinde einer Schraube) oder konische Kontakte. Ebenso wird geprüft, ob sich Körper überschneiden, sogenannte "Fixierende Kontakte". Solche Kontakte können zum Beispiel ein Sicherungsring sein. Dieser hat im entspannten Zustand einen kleineren Innendurchmesser als das Bauteil, an dem es angebracht wird.

In einem weiteren Schritt wird bevorzugt eine Matrix erstellt, die eine Vielzahl von Bauteilen beinhaltet, wobei alle Bauteile, die in der Matrix beschrieben werden sollen, jeweils auf der x- und y-Achse der Matrix dargestellt sind, wobei die Einträge der Matrix beschreiben, welche Art des primitiven Kontaktfeatures vorliegt. Eine erfindungsgemäße Matrix könnte aussehen wie in Tabelle 1 dargestellt.

Tabelle 1 stellt eine erfindungsgemäße Matrix dar. B1-Bn sind dabei Bauteile des erfindungsgemäßen digitalen Modells. Die Einträge in der Matrix basieren auf den primitiven Kontaktfeatures. Die unterschiedlichen Zahlen in der Matrix geben die Kontaktart zwischen den Bauteilen an. So definiert zum Beispiel "-", dass es sich um dasselbe Bauteil handelt. Der Eintrag 2 könnte zum Beispiel ein konischer Kontakt sein, 3 ein planarer Kontakt, etc. Ein Bauteil könnte auch mehrere Kontaktarten haben. Diese werden ebenfalls in der Matrix dargestellt. Dies kann entweder weiterhin mit einer einzelnen Zahl passieren. So könnte zum Beispiel 5 planarer und zylindrischer Kontakt bedeuten,oder durch eine Reihe von Zahlen, die alle Kontaktarten aufzählt z.B. [2, 3]. Zusätzliche Informationen zur Kontaktart können in einer optionalen Datenbank gespeichert werden.

**Tabelle 1: Matrix Repräsentation der primitiven Kontaktfeatures**

| B1 | B2 | B3 | ... | Bn | |
|---|---|---|---|---|---|
| B1 | - | 2 | 0 | x | 3 |
| B2 | 2 | - | 4 | x | 0 |
| B3 | 0 | 4 | - | x | 0 |
| ... | x | x | x | - | 0 |
| Bn | 3 | 0 | 0 | 0 | - |

Basierend auf dieser Matrix und/oder einigen der primitiven Kontaktfeatures werden bevorzugt höherstufige Kontaktfeatures bestimmt. Für höherstufige Kontaktfeatures wird zum Beispiel geprüft, ob bei einem zylindrischen Kontakt eine Durchgangsbohrung oder eine angesenkte Durchgangsbohrung oder ein Sackloch vorliegt. Diese Kombination von Kontaktfeatures wird genutzt, um keine, eine oder mehrere freie Ausbaurichtung eines Bauteils zu identifizieren. In anderen Worten werden für bestimmte primitive Kontaktfeatures höherstufige Kontaktfeatures bestimmt, welche die freien Ausbaurichtungen des auszubauenden Bauteils auf Grund geometrischer Eigenschaften mindestens eines der Bauteile beschränken.

Die freien Ausbaurichtungen eines Bauteils können maximal 6 oder 12 betragen. Die freien Ausbaurichtungen können sich hierbei durch je drei translatorische und drei rotatorische Freiheitsgrade ergeben, die jeweils eine Bewegung in zwei Richtungen erlauben.

In einer optionalen Ausführungsform werden die freien Ausbaurichtungen des auszubauenden Bauteils im Koordinatensystem des auszubauenden Bauteils des Bauteilpaars oder im Koordinatensystem des Bauteilpaars angegeben.

Ein Bauteilpaar entspricht den voneinander zu trennenden Bauteilen.

In einer optionalen Ausführungsform der Erfindung wird überprüft, ob entlang der freien Ausbaurichtung ein anderes Bauteil im Weg ist, mit dem das auszubauende Bauteil kollidieren könnte. In anderen Worten ist die freie Ausbaurichtung eine Richtung, in der das mindestens eine gefundene Bauteil von dem zusammengesetzten Modell getrennt werden kann, ohne mit einem anderen Bauteil zu kollidieren.

In einer weiteren optionalen Ausführungsform der Erfindung wird überprüft, ob entlang der freien Ausbaurichtung ein anderes Bauteil im Weg ist, welches weder das Bauteil selbst noch das Bauteil, von dem es ursprünglich getrennt wurde, ist mit dem das auszubauende Bauteil kollidieren könnte. In anderen Worten findet eine Überprüfung der Kollision mit einem anderen Bauteil, welches auch die Überprüfung der Kollision mit einem zusätzlichen Bauteil betrifft, das nicht zu den voneinander zu trennenden Bauteilen gehört, statt.

In einer optionalen Ausführungsform wird die Kollisionsanalyse mit Hilfe einer Projektion des auszubauenden Bauteils durchgeführt.

In einer optionalen Ausführungsform werden nur Ausbaurichtungen zwischen Bauteilen ermittelt, die sich berühren.

In einer optionalen Ausführungsform werden alle Ausbaurichtungen zwischen allen Bauteilen ermittelt.

Die oben genannten Schritte können iterativ für jeden Montageschritt durchgeführt werden, wobei das digitale Modell nach gegenwärtig demontierbaren Bauteilen analysiert werden kann, wobei bereits demontierte Bauteile unberücksichtigt bleiben können.

Demontierbare Bauteile sind beispielsweise Bauteile, die mindesten eine freie Ausbaurichtung aufweisen.

In einer optionalen Ausführungsform der Erfindung wird bei jedem schrittweisen Demontageschritt nach mindestens einem Bauteil gesucht, bei dem mindestens eine freie Ausbaurichtung existiert.

Resultierend aus der Ermittlung der freien Ausbaurichtungen und Kollisionen ergeben sich Montageinformationen, die einem Editor übergeben werden können.

Montageinformationen können alle Montageschritte oder ein Subset von Montageschritten oder einen einzelnen Montageschritt enthalten. So können die Montageinformationen zum Beispiel alle oder ein Subset der freien Ausbaurichtungen sowie das/die zu trennenden Bauteilpaare für den entsprechenden Ausbauschritt oder alle Ausbauschritte oder alle Bauteile oder ein Subset aller Bauteile des digitalen Modells beinhalten.

Die Montageinformationen werden zum Erstellen einer grafischen Darstellung mindestens eines Demontageschritts oder Montageschritts für einen Nutzer genutzt. Eine grafische Darstellung kann zum Beispiel ein Dokument im.doc, .docx, .pdf, .xml, .html, oder gleichwertigem Format sein. Weiterhin bevorzugt ist eine grafische Darstellung in Form eines 2-D, oder 3-D Editor Files, welches die entsprechende Montagesequenzen inklusive der Animationen gespeichert hat. Dieses 2-D, oder 3-D Editor File kann beispielsweise in einer .glb, .gltf, oder gleichwertigem Format gespeichert sein und optional mit Metainformationen, welche bevorzugt in einem inkludierten oder separaten .json-File gespeichert sind vorliegen. Weiterhin bevorzugt ist eine grafische Darstellung als Bild zum Beispiel im .tiff, .gif, .jpg,.png, oder gleichwertigem Format, oder als Video zum Beispiel im.mp4, .avi, .mov, oder gleichwertigem Format..

In einer optionalen Ausführung der Erfindung wird in der grafischen Darstellung entgegen der freien Ausbaurichtung der zu trennenden Bauteile automatisch ein richtungsanzeigendes Element, insbesondere ein Pfeil, eingefügt.

In einer optionalen Ausführung der Erfindung wird analysiert, ob zum Trennen der zu trennenden Bauteile ein Werkzeug benötigt wird. Beispielsweise könnte erkannt werden, dass eines der zu trennenden Bauteile eine Schraube ist.

In einer optionalen Ausführung der Erfindung wird in der grafischen Darstellung ein passendes Werkzeug zum Trennen der beiden zu trennenden Bauteile angezeigt. Zum Beispiel könnte ein Schraubendreher im Zusammenhang mit einer Schraube angezeigt werden. Zusätzlich könnte auch die passende Art des Schraubendrehers, wie Kreuz, Schlitz, Pentalobe, etc. angezeigt werden.

In einer optionalen Ausführung der Erfindung werden in der grafischen Darstellung alle oder ein Subset der zu verbauenden Bauteile in diesem Montage Schritt in einer Stückliste angezeigt.

In einer optionalen Ausführung der Erfindung sind die zu Verbauenden Bauteile Maßstabsgetreu oder in einem angegebenen Maßstab, beispielsweise in der Stückliste, angegeben.

Im Folgenden werden bevorzugte Ausführungsformen der Erfindung anhand von Figuren erläutert.

Es zeigen:
Fig. 1 a-d eine bevorzugte Ausführungsform der erfindungsgemäßen erstellten technischen Montageanleitung für ein Regal
Fig. 2 eine geschnittene Seitenansicht einer abgesenkten Bohrung und Ihre Kontaktflächen
Fig. 3 ein einfaches Beispiel für eine Schraubverbindung von 2 Platten

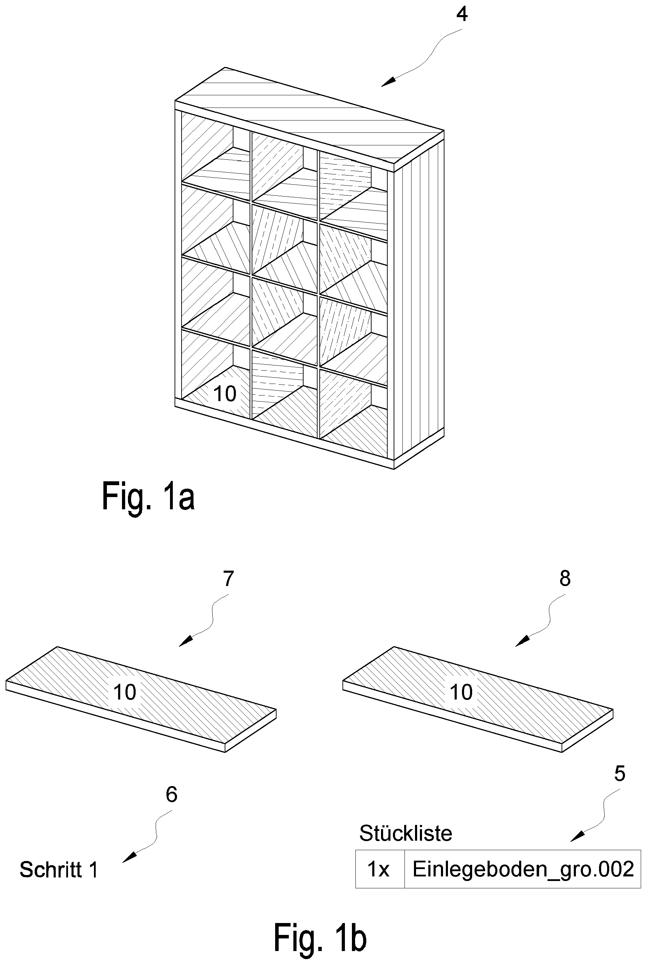

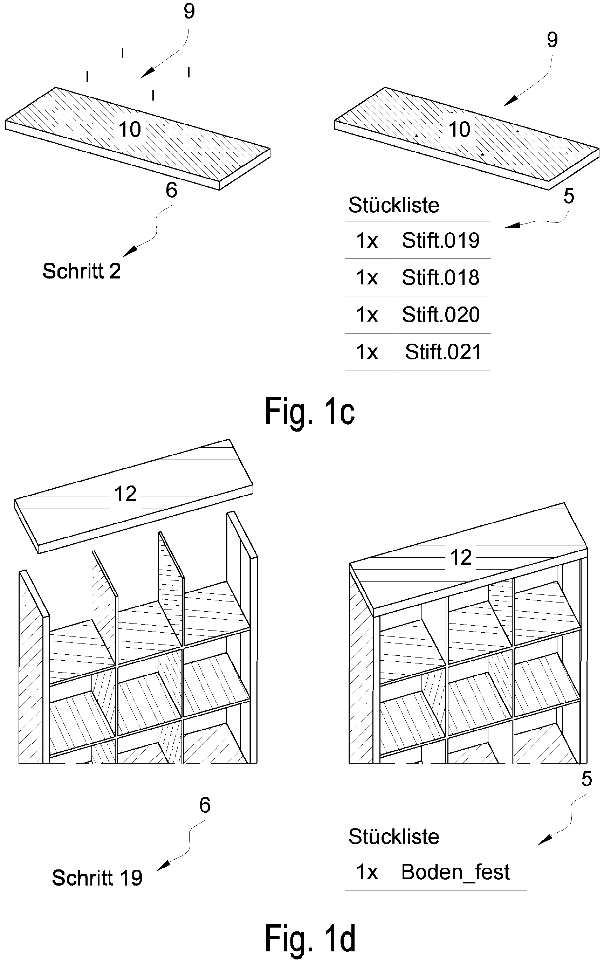

Fig. 1 a - Fig. 1 d zeigen eine bevorzugte Ausführungsform einer erfindungsgemäß erstellten Montageanleitung. Dieses Beispiel zeigt, wie eine Montage Schritt für Schritt iterativ dargestellt werden könnte.

Fig. 1 a zeigt in dieser beispielhaften Ausführungsform das vollständig zusammengebaute digitale Modell 4. Einzelne Bauteile können in dieser Darstellung unterschiedlich eingefärbt vorliegen (hier durch unterschiedliche Schraffuren dargestellt). Bauteil 10, welches ebenfalls in den folgenden Figuren abgebildet ist, ist beispielsweise markiert.

Fig. 1 b zeigt in dieser bevorzugten Ausführungsform die Darstellung eines möglichen ersten Montageschritts, welcher die Montageinformationen des ersten Montageschritts darstellt. Die optionale Stückliste 5 weist auf die benötigten Bauteile für den entsprechenden Schritt hin. Der optionale Schrittzähler 6 weist auf den entsprechenden Montageschritt hin. Der linke Zustand 7 könnte jeweils den Ausgangszustand des letzten Montageschritts inklusive der neu zu montierenden Bauteile anzeigen. Der rechte Zustand 8 könnte jeweils den zusammengefügten Zustand der in diesem Montageschritt zusammenzufügenden Bauteile anzeigen. In diesem Beispiel wird nur ein Bauteil - Bauteil 10 - montiert, da es der erste Montageschritt ist.

Fig. 1 c zeigt in dieser bevorzugten Ausführungsform die Darstellung eines möglichen zweiten Montageschritts. Auf der linken Seite sind Stifte 9 im unmontierten Zustand zu erkennen. Auf der rechten Seite sind Stifte 9 im montierten Zustand mit Bauteil 10 zu erkennen.

Fig. 1 d zeigt in dieser bevorzugten Ausführungsform die Darstellung eines möglichen letzten Montageschritts. Auf der linken Seite ist Bauteil 12 im unmontierten Zustand zu erkennen. Auf der rechten Seite ist Bauteil 12 im montierten Zustand zu erkennen. Es ist ebenfalls erkennbar, dass sich der Bildausschnitt im Vergleich zu den anderen Montageschritten geändert hat.

Es sei darauf hingewiesen, dass die erfindungsgemäße Methode oder Vorrichtung zum Erstellen der Montageanleitung die Fig. 1a-1d in einer anderen Reihenfolge erstellt. Die hier dargestellte Reihenfolge entspricht einer bevorzugten grafischen Darstellung.

Die erfindungsgemäße Methode oder Vorrichtung beginnt jedoch mit dem vollständig zusammengebauten digitalen Modell 4 in Figur 1a und geht dann Schritt für Schritt die Demontage durch. Der erste Demontageschritt entspricht demnach dem letzten Montageschritt dargestellt in Fig. 1d, gefolgt von vielen weiteren Demontageschritten, bis hin zum letzten Demontageschritt, welcher der erste Montageschritt ist, dargestellt in Fig. 1b.

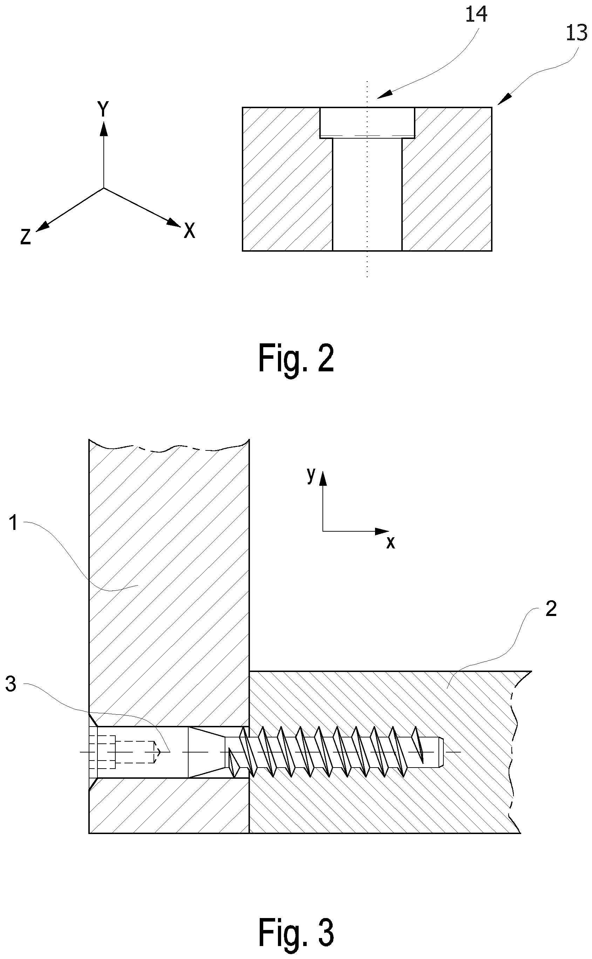

Fig. 2 zeigt Kontaktfeatures zwischen zwei Bauteilen. Dieses Beispiel zeigt eine zylindrisch abgesenkte Bohrung in einem Bauteil 13 mit einer Schraube 14. Die beiden Bauteile haben je zwei Kontaktfeatures untereinander. Die gestrichelte Linie weist auf einen planaren Kontakt hin, der die freie Ausbaurichtung in -Y behindert. In +Y Richtung wäre die Schraube 14 entfernbar. Die gepunktete Linie weist auf einen zylindrischen Kontakt hin, der die freien Ausbaurichtungen in -X, +X, -Z und +Z einschränkt. Per Ausschlussprinzip ergibt sich hierdurch eine freie Ausbaurichtung in Richtung +Y für die Schraube 13 in der absenkten Bohrung des Bauteils 14 dieses Beispiels.

In einer bevorzugten Ausführungsform der Erfindung werden basierend aus den Kontaktfeatures aus Fig. 2 ebenfalls potenzielle Drehrichtungen bestimmt. So lässt sich die Schraube, ohne Berücksichtigung des Gewindes in obigem Beispiel, beispielsweise um die Y-Achse in zwei Richtungen drehen, nicht jedoch um die X-, oder Z-Achse, da der konische Kontakt diese Rotation verhindert und die Schraube mit dem anderen Bauteil kollidieren würde.

Ein Bauteilpaar entspricht den voneinander zu trennenden Bauteilen. In Fig. 3 wären dies zum Beispiel Platte 1 und Schraube 3., sowie Platte 1 von Platte 2 und Platte 2 von Schraube 3.

Fig. 3 beschreibt die Demontage von zwei Platten mit Hilfe einer Schraube mit den Bauteilen Platte 1, Platte 2 und Schraube 3.

Zunächst werden die Kontaktfeatures zwischen den Komponenten bestimmt, z.B. planarer Kontakt zwischen Platte 1 und Platte 2, zylindrischer und planarer Kontakt zwischen Platte 1 und Schraube 3, sowie zylindrischer Kontakt zwischen Platte 2 und Schraube. Basierend auf diesen Kontaktfeatures würden sich für die Bauteile 1-3 aufgrund der abgesenkten Bohrung nur -X für die Schraube 3 als Demontagerichtung anbieten, für die Platte 2 die Richtung in +X. Ebenso hätte das Bauteilpaar 3-2 die Demontagerichtungen -X für die Schraube und +X für die Platte 2. Beim Bauteilpaar 1-2 wären aufgrund des Planaren Kontaktes die Demontagerichtungen -X, +Y und -Y für Platte 1 möglich, bei Platte 2 +X, -Y und +Y.

In einer bevorzugten Ausführungsform werden mögliche freie Ausbaurichtungen nun für ein Bauteil mithilfe einer Kollisionsanalyse ermittelt, indem geprüft wird, ob Kollisionen vorliegen. Im Beispiel in Fig. 3 würde beispielsweise Platte 1 geprüft werden. Für diese gibt es die Ausbaurichtungen +Y, -Y, +X (aus dem Bauteilpaar 1-2) und die Ausbaurichtungen +X (aus dem Bauteilpaar 1-3). Damit würden bei einer Demontage Platte 2 in -Y und +Y Richtung mit der Schraube 3 kollidieren. Diese Informationen zu möglichen Kollisionen werden ebenfalls berücksichtigt beim Bestimmen von freien Ausbaurichtungen.

## Patentansprüche

1. Verfahren zum automatisierten Generieren einer technischen Montageanleitung aus einem digitalen Modell des zusammengesetzten Gegenstandes, insbesondere eines CAD Modells,
wobei das digitale Modell mindestens zwei Bauteile aufweist, **gekennzeichnet durch** folgende Verfahrensschritte:
- Schrittweises Demontieren der Bauteile des digitalen Modells
- Erstellen der technischen Montageanleitung auf Basis des schrittweisen Demontierens in umgekehrter Reihenfolge.

2. Verfahren nach Anspruch 1, wobei bei jedem schrittweisen Demontageschritt nach mindestens einem Bauteil gesucht wird, bei dem mindestens eine freie Ausbaurichtung existiert.

3. Verfahren nach Anspruch 2, wobei die freie Ausbaurichtung eine Richtung ist, in der das mindestens eine gefundene Bauteil von dem zusammengesetzten Modell getrennt werden kann, ohne mit einem anderen Bauteil zu kollidieren.

4. Verfahren nach einem der Ansprüche 1-3, wobei das schrittweise Demontieren der Bauteile des digitalen Modells mit dem vollständig zusammengesetzten Modell beginnt.

5. Verfahren nach einem der Ansprüche 1-4, wobei die technische Montageanleitung mit einem Subset der Bauteile des vollständig zusammengesetzten digitalen Modells beginnt.

6. Verfahren nach Anspruch 2-5, **gekennzeichnet durch** den Schritt:
Ermitteln, ob sich zwei Bauteile berühren,
ermitteln eines primitiven Kontaktfeatures, welches beschreibt, auf welche Art sich zwei Bauteile berühren.

7. Verfahren nach Anspruch 6, **gekennzeichnet durch** den Schritt:
Erstellen einer Matrix, die eine Vielzahl von Bauteilen beinhaltet, wobei alle Bauteile, die in der Matrix beschrieben werden sollen, jeweils auf der X- und Y-Achse der Matrix dargestellt sind, wobei die Einträge der Matrix beschreiben, welche Art des primitiven Kontaktfeatures vorliegt.

8. Verfahren nach einem der Ansprüche 6-7, wobei für bestimmte primitive Kontaktfeatures höherstufige Kontaktfeatures bestimmt werden, welche die freien Ausbaurichtungen des auszubauenden Bauteils auf Grund geometrischer Eigenschaften mindestens eines der Bauteile weiter beschränken.

9. Verfahren nach einem der Ansprüche 2-8, wobei mindestens keine, eine, oder mehrere freie Ausbaurichtung basierend auf mindestens drei translatorischen Freiheitsgraden bestimmt wird, wobei die drei translatorischen Freiheitsgrade sechs potenziellen Ausbaurichtungen entsprechen, wobei freie Ausbaurichtungen potenziellen Ausbaurichtungen entsprechen, bei denen das auszubauende Bauteil entlang der freien Ausbaurichtung mit keinem anderen Bauteil kollidiert
oder,
wobei mindestens eine freie Ausbaurichtung basierend auf mindestens drei rotatorischen Freiheitsgraden bestimmt wird, wobei die drei rotatorischen Freiheitsgrade sechs potenziellen Drehrichtungen entsprechen, wobei freie Ausbaurichtungen potenziellen Drehrichtungen entsprechen, bei denen das auszubauende Bauteil entlang der freien Ausbaurichtung mit keinem anderen Bauteil kollidiert.

10. Verfahren nach einem der Ansprüche 2-10, wobei die Überprüfung der Kollision mit einem anderen Bauteil, auch die Überprüfung der Kollision mit einem zusätzlichen Bauteil betrifft, das nicht zu den voneinander zu trennenden Bauteilen gehört.

11. Verfahren nach einem der Ansprüche 1-11, **gekennzeichnet durch** den folgenden Verfahrensschritt:
a. Erstellen einer grafischen Darstellung mindestens eines Demontageschritts oder Montageschritts für einen Nutzer.

12. Verfahren nach einem der Ansprüche 2-12, wobei entgegen der freien Ausbaurichtung der zu trennenden Bauteile automatisch ein richtungsanzeigendes Element, insbesondere ein Pfeil eingefügt wird.

13. Verfahren nach einem der Ansprüche 2-12, **dadurch gekennzeichnet, dass** nur Ausbaurichtungen ermittelt werden zwischen Bauteilpaaren, welche sich berühren,
oder,
dass das digitale Modell nach gegenwärtig demontierbaren Bauteilen analysiert wird, wobei bereits demontierte Bauteile unberücksichtigt bleiben
oder
die freien Ausbaurichtungen des auszubauenden Bauteils im Koordinatensystem des auszubauenden Bauteils des Bauteilpaars oder im Koordinatensystem des Bauteilpaars angegeben werden.

14. Vorrichtung zur Durchführung des Verfahrens nach einem der Ansprüche 1-13, zum automatisierten Generieren einer technischen Montageanleitung aus einem digitalen Modell.

15. Computerlesbares Medium, welches Informationen zur Durchführung des Verfahrens nach einem der Ansprüche 1-13, zum automatisierten Generieren einer technischen Montageanleitung aus einem digitalen Modell enthält.
